# EUROPEAN PATENT APPLICATION

(11) **EP 2 248 855 A1**
(43) Date of publication of application: **10.11.2010**
(21) Application number: 08872604.7
(22) Date of filing: 04.08.2008
(51) Int. Cl.: C08L 63/00, C08K 9/04

(54) **PROCESS FOR PRODUCING RESIN COMPOSITION WITH PARTIAL-DISCHARGE RESISTANCE, RESIN COMPOSITION WITH PARTIAL-DISCHARGE RESISTANCE, AND INSULATING MATERIAL WITH PARTIAL-DISCHARGE RESISTANCE**

(30) Priority: 18.02.2008 JP 2008036469
(71) Applicant: Kabushiki Kaisha Toshiba, Minato-ku Tokyo 105-8001 (JP); A School Corporation Kansai University, Suita-shi, Osaka 564-8680 (JP)
(72) Inventor: OZAKI, Tamon, Minato-ku Tokyo 105-8001 (JP); IMAI, Takahiro, Minato-ku Tokyo 105-8001 (JP); SAWA, Fumio, Minato-ku Tokyo 105-8001 (JP); MURAYAMA, Kiyoko, Minato-ku Tokyo 105-8001 (JP); KOMIYA, Gen, Minato-ku Tokyo 105-8001 (JP); SHIMIZU, Toshio, Minato-ku Tokyo 105-8001 (JP); TODO, Yoko, Minato-ku Tokyo 105-8001 (JP); HOMMA, Mitsukazu, Minato-ku Tokyo 105-8001 (JP); SAKAGUCHI, Osamu, Minato-ku Tokyo 105-8001 (JP); OCHI. Mitsukazu, Suita-chi Osaka 564-8680 (JP); KURAYA, Miyuki, Suita-chi Osaka 564-8680 (JP)
(74) Representative: HOFFMANN EITLE
(86) International application number: PCT/JP2008/063965
(87) International publication number: WO 2009/104292

(57) **Abstract**

Fabricating a partial discharge resistant resin composite with an excellent partial discharge resistance with a small density, in a simplified manner. Using an ion exchange treatment for intercalating an organic compound between layers of a layer clay mineral thereby providing the layer clay mineral with a swellability to at least one of a polar solvent and a non-polar solvent, having the layer clay mineral as provided with a swellability swollen in a swelling solvent comprising the polar solvent or the non-polar solvent, followed by mixing an epoxy resin and kneading, making a removal of the swelling solvent from an obtained mixture including the swelling solvent, the layer clay mineral, and the epoxy resin, adding a hardener for epoxy resin to the mixture including the layer clay mineral and the epoxy resin, and mixing the mixture. In a partial discharge resistant insulation material comprising a hardened material of a partial discharge resistant resin composite thus fabricated, there is a network of molecular chains (1) of the epoxy resin constituting a cross-linked structure, with a system of inorganic nanoparticles (2) comprising the layer clay mineral and precisely and evenly dispersed therein.

## Description

### Technical Field

The present invention relates to a fabrication method for partial discharge resistant resin composites, a partial discharge resistant resin composite, and a partial discharge resistant insulation material applicable to high voltage equipments such as electric generators, rotating machines, equipments for electric transmission and transformation, or equipments for electric distribution or reception, for instance.

### Background Art

There are insulated coils incorporated in electric generators, rotating machines, or the like, and provided with insulation layers for isolation between current conducting conductors or between conductors and the ground. In equipments for electric transmission or transformation such as sulfur hexafluoride gas-insulated switchgears or gas-insulated transmission lines, there are cast articles employed as insulation members for insulating and supporting high voltage conductors in metallic casings, for instance. For such insulation layers or cast articles for high voltage equipments, generally used are insulation resin materials having epoxy resins as base materials.

Insulation layers of insulated coils fabricated mostly include mica papers such as those made of non-burned hard mica clumps or burned hard mica clumps and impregnated with epoxy resins (refer to patent literature 1 for instance), while mica itself has an excellent resistance property to partial discharges, affording for an entirety of insulation layer as well to exhibit a partial discharge resistance. Also, as a typical cast article to be cited, there is an insulating spacer made of the epoxy resin containing an amount of inorganic material particles several times greater by weight than that of epoxy resin, obtaining necessary characteristics including the partial discharge resistance (refer to patent literatures 2 and 3 for instance).

In addition, in the field of industrial low-voltage motors, inverter-fed motors become popular to control speed. However, recent years have observed occasional inverter surges damaging motors, with a desideratum for a material to be highly resistant to partial discharges as an insulating material for coverage of motor wilings. To this point, as a reported example, there has been use of sol-gel reactions for precipitation of silica particles in polyamide-imide, to provide a resistant property to partial discharges (refer to patent literature 4 for instance).

However, for the above-noted insulation layers of insulated coils, available epoxy resins for impregnation themselves have been provided with low resistances to the deterioration by partial discharge, so parts of epoxy resin have undergone selective deterioration, involving a gradual progress of deterioration with respect to an entirety of insulation layer, too. As to the insulating spacer made of the epoxy resin containing an amount of inorganic material particles several times higher than that of epoxy resin, the insulating material has been subject to an increased density, constituting a difficulty in light-weighting high-voltage equipments. Also, in the method of using sol-gel reactions for precipitation of silica particles, there has been the need of controlling sol-gel reactions to precipitate even particles, with complicated fabrication processes and equipments costing high.
Patent Literature 1: JP 3,167,479
Patent Literature 2: JP 54-44106 B
Patent Literature 3: JP 55-155512A
Patent Literature 4: JP 2004-22831 A

### Summary of Invention

### Technical Problem

As described, there have been insulation layers of insulated coils to be incorporated in electric generators, rotating machines or the like with impregnated epoxy resins themselves having low resistances to partial discharge deterioration, causing a gradual progress of deterioration with respect to an entirety of insulation layer, too, as an issue. Also, there has been an insulating spacer made of the epoxy resin containing an amount of inorganic material particles several times higher than that of epoxy resin, subject to an increased density of insulating material constituting a difficulty in light-weighting high-voltage equipments. In addition, there has been a method of using sol-gel reactions for precipitation of silica particles to provide an insulating cover material with a partial discharge resistance, involving complicated fabrication processes and equipments costing high, as an issue.

The present invention has been devised to cope with such issues, it thus being an object of the present invention to provide a fabrication method for partial discharge resistant resin composites, a partial discharge resistant resin composite, and a partial discharge resistant insulation material, allowing for fabrication of a partial discharge resistant resin composite with an excellent partial discharge resistance with a small density, in a simplified manner.

### Solution to Problem

According to an aspect of the present invention there is a fabrication method for partial discharge resistant resin composites containing (A) an epoxy resin having two or more epoxy groups per one molecule, (B)an hardener for an epoxy resin, and (C) a layer clay mineral as indispensable ingredients, the fabrication method for partial discharge resistant resin composites comprising steps of using an ion exchange treatment for intercalating an organic compound between layers of a layer clay mineral thereby providing the layer clay mineral with a swellability to at least one of a polar solvent and a non-polar solvent, having the layer clay mineral as provided with a swellability swollen in a swelling solvent comprising the polar solvent or the non-polar solvent, kneading a mixture of an epoxy resin and the swelling solvent including the layer clay mineral as swollen, making a removal of the swelling solvent from the mixture including the swelling solvent, the layer clay mineral, and the epoxy resin after the kneading, and mixing an epoxy resin addressing hardener with the mixture after the removal of the swelling solvent.

According to another aspect of the present invention there is a partial discharge resistant resin composite fabricated by a fabrication method for partial discharge resistant resin composites according to the above-noted aspect of the present invention.

According to another aspect of the present invention there is a partial discharge resistant insulation material comprising a hardened material of a partial discharge resistant resin composite according to the other aspect of the present invention.

### Advantageous Effects of Invention

According to an aspect of the present invention, there is an epoxy resin enabled to have a system of inorganic nanoparticles comprising a layer clay mineral and evenly dispersed therein, affording to obtain a partial discharge resistant resin composite as well as a partial discharge resistant insulation material with an excellent partial discharge resistance with a small density. There is no need of complicated fabrication processes or equipments, it being possible to provide a partial discharge resistant resin composite as well as a partial discharge resistant insulation material with an excellent partial discharge resistance with a favorable repeatability.

### Brief Description of Drawings

Fig. 1 is a schematic illustration of a microstructure of a partial discharge resistant insulation material according to an embodiment of the present invention.
Fig. 2 is a set of schematic illustrations of a system of inorganic nanoparticles dispersed in a partial discharge resistant insulation material according to an embodiment example 1, and those in insulation materials according to comparative examples 1 to 3.
Fig. 3 is a schematic view of an electrode configuration employed for evaluation of a partial discharge resistant characteristic.
Fig. 4 is a plot of values of surface roughness after partial discharge deterioration of a partial discharge resistant insulation material according to the embodiment example 1, and those of insulation materials according to the comparative examples 1 to 3.
Fig. 5 is a set of schematic illustrations of a situation of deterioration due to partial discharges in the embodiment example 1, and that in the comparative example 1.
Fig. 6 is a set of graphs plotting results of an X-ray diffraction analysis representing a condition of layer clay mineral in an epoxy resin in the embodiment example 1, and those in the comparative example 3.
Fig. 7 is a schematic perspective view of a partial discharge resistant insulation structure using a partial discharge resistant insulation material according to an aspect of the present invention.
Fig. 8 is an explanatory view of another partial discharge resistant insulation structure using a partial discharge resistant insulation material according to an aspect of the present invention.
Fig. 9 is a sectional view of still another partial discharge resistant insulation structure using a partial discharge resistant insulation material according to an aspect of the present invention.

### Description of Embodiments

There will be described embodiments of the present invention. According to an embodiment of the present invention there is a set of partial discharge resistant resin composites each containing (A) an epoxy resin having two or more epoxy groups per one molecule, (B) an hardener for an epoxy resin, and (C) a system of inorganic nanoparticles comprising a layer clay mineral or layer clay minerals, as indispensable ingredients thereof.

Among the indispensable ingredients for a respective partial discharge resistant resin composite, the ingredient (A) should be an epoxy resin comprising an epoxy compound having two or more epoxy groups per one molecule. As such the epoxy compound, employed as necessary without limitation to the kind may be any of those compounds having in one molecule tow or more three-membered rings each comprising two carbon elements and one oxygen element, and curable.

For the ingredient (A), specific examples of epoxy resin cited may be such as glycidyl ether type epoxy resins obtainable by condensation between epichlorohydrin and any of polyalcohols or polyphenols such as bisphenols, including bisphenol A type epoxy resins, brominated bisphenol A type epoxy resins, hydrogenated bisphenol A type epoxy resins, bisphenol F type epoxy resins, bisphenol S type epoxy resins, bisphenol AF type epoxy resins, biphenyl type epoxy resins, naphthalene type epoxy resins, fluorene type epoxy resins, novolac type epoxy resins, phenol novolac type epoxy resins, orthocresol novolac type epoxy resins, tris(hydroxyphenyl)methane type epoxy resins, and tetraphenyrolethane type epoxy resins, glycidyl ester type epoxy resins obtainable by condensation between epichlorohydrin and a carboxylic acid, with triglycidyl isocyanate inclusive, or heterocyclic epoxy resins like hydantoin type epoxy resins obtainable by reaction between epichlorohydrin and any of hydantoins, whichever may be employed alone or in combination as a mixture of two or more kinds, as an epoxy resin.

For the ingredient (B), there may be used any of hardeners reactive with an epoxy resin or epoxy resins to harden the same, and selected as necessary without limitation to the kind. As such epoxy resin addressing hardeners, there may be cited for instance amine series hardeners, acid anhydride series hardeners, imidazole series hardeners, polymercaptan series hardeners, phenol series hardeners, Lewis acid series hardeners, isocyanate series hardeners, and the like.

As the above-noted amine series hardeners, specific examples cited may be ethylenediamine, 1,3-diaminopropane, 1,4-diaminobutane, hexamethylenediamine, dipropylenediamine, polyetherdiamine, 2,5-dimethylhexamethylenediamine, trimethylhexamethylenediamine, diethylenetriamine, iminobispropylamine, bis(hexamethyl)triamine, triethylenetetramine, tetraethylenepentamine, pentaethylenehexamine, aminoethylethanolamine, tri(methylamino)texane, dimethylaminopropylamine, diethylaminopropylamine, methyliminobispropylamine, menthanediamine, isophoronediamine, bis(4-amino-3-methyldicyclohexyl)methane, diaminodicyclohexylmethane, bis(aminomethyl)cyclohexane, N-aminoethylpiperazine, 3,9-bis(3-ammopropyl)2,4,8,10-tetraoxaspiro(5,5)undecane, m-xylenediamine, meta-phenylenediamine, diamino diphenyl methane, diamino diphenyl sulfone, diamino diethyl diphenyl methane, dicyandiamide, organic acid dihydrazide, and the like.

For the acid anhydride series hardeners, specific examples cited may be dodecenyl succinic anhydrides, poly adipic anhydrides, polyazelaic polyanhydrides, poly sebacic anhydrides, poly (ethyloctadecanedioic) anhydrides, poly (phenylhexadecanedioic) anhydrides, methyltetrahydrophthalic anhydride, methylhexahydrophthalic anhydrides, methylhimic anhydrides, hexahydrophthalic anhydrides, tetrahydrophthalic anhydrides, trialkyltetrahydrophthalic anhydrides, methylcyclohexenedicarboxylic anhydrides, phthalic anhydrides, trimellitic anhydrides, pyromellitic anhydrides, benzophenontetracarboxylic acids, ethylene glycol bis trimellitates, glycerol tris trimellitates, het anhydrides, tetrabromophthalic anhydrides, nadic anhydrides, and poly azelaic anhydrides.

For the imidazole series hardeners, specific examples cited may be 2-methylimidazole, 2-ethyl-4- methylimidazole, 2-heptadecylimidazole, and the like. For the polymercaptan series hardeners, specific examples cited may be polysulfides, tioesters, and the like. The above-noted hardeners may be employed alone or in combination as a mixture of two or more kinds, as a hardener.

For the ingredient (B), the amount of hardener or hardeners blended may be set as necessary within a range of effective amounts such as those depending on the kind or kinds of hardener or hardeners in use, and typically, may preferably be within, a range of one half to two equivalents to an epoxy equivalent of the epoxy resin. For the ingredient (B), if the hardener blend amount is less than one half equivalents to the epoxy equivalent of the ingredient (A), there might be anxieties about insufficiency to develop epoxy resin hardening reactions for the ingredient (A). On the other hand, for the ingredient (B), if the hardener blend amount exceeds two equivalents to the epoxy equivalent of the ingredient (A), there may be degraded basic physical properties such as heat resistances of hardened materials in partial discharge resistant resin composites (epoxy resin composites).

Further, for the ingredient (B), there may be use of the hardener in combination with use of curing accelerators adapted to accelerate or control hardening reactions of the epoxy resin. In particular, the use of curing accelerator may have an increased chance, in use of any of acid anhydride series hardeners that is slower in rate of hardening reaction than other hardeners such as amine series hardeners. For acid anhydride series hardeners, curing accelerators used may preferably be tertiary amines or salts thereof, quaternary ammonium compounds, imidazoles, alkali metal alkoxides, or the like.

For the ingredient (C), the system of inorganic nanoparticles comprising a layer clay mineral or layer clay minerals may preferably have a blend amount thereof set within a range of 1 to 50 parts by weight to 100 parts by weight of the epoxy resin of the ingredient (A). For the ingredient (C), if the blend amount of inorganic nanoparticles is less than 1 part by weight to 100 parts by weight of the ingredient (A), there may be failures to provide hardened materials of epoxy resin with partial discharge resistant characteristics. On the other hand, for the ingredient (C), if the blend amount of inorganic nanoparticles exceeds 50 parts by weight to 100 parts by weight of the ingredient (A), there may be an increase in viscosity of the epoxy resin, constituting a difficulty to provide a system of inorganic nanoparticles evenly dispersed in the epoxy resin. Also, there may be brittle hardened materials of epoxy resin provided as partial discharge resistant insulation materials with degraded basic characteristics.

For the ingredient (C), preferably, the system of inorganic nanoparticles comprising a layer clay mineral or layer clay minerals should have initial particle sizes of 500 nm or less. For the ingredient (C), if the system of inorganic nanoparticles has initial particle sizes greater than 500 nm, there may be failures to provide hardened materials of epoxy resin with partial discharge resistant characteristics within the range of 1 to 50 parts by weight to 100 parts by weight of the epoxy resin of the ingredient (A).

For the ingredient (C), layer clay minerals cited may belong to at least one of mineral groups including for instance the smectite group, mica group, vermiculite group, and groups in the mica family. As layer clay minerals belonging to the smectite group there may be cited motmorillonite, hectorite, saponite, sauconite, beidellite, stevensite, nontronite, and the like. As layer clay minerals belonging to the mica group there may be cited chlorite, phlogopite, lepidolite, muscovite, biotite, paragonite, margarite, taeniolite, tetrasilicicmica, and the like. As layer clay minerals belonging to the vermiculite group there may be cited trioctahedral vermiculite, dioctahedral vermiculite, and the like. As layer clay minerals belonging to the mica family groups there may be cited muscovite, biotite, paragonite, lepidolite, margarite, clintonite, anandite, and the like. Among them, preferably, those layer clay minerals belonging to the smectite group should be used in view of the tendency of dispersion to epoxy resins, or such. The above-noted layer clay minerals may be employed alone or in combination as a mixture of two or more kinds.

Layer clay minerals have structures in which silicate layers are laminated, affording to hold various substances such as ions, molecules, or clusters intercalated between silicate layers by ion exchange reactions (intercalation). Such use of ion exchange treatments permit various metal ions or organic compounds to be intercalated between silicate layers. Such behaviors are utilized to permit various organic compounds to be used as interlayer substances intercalated to hold between silicate layers of layer clay minerals, allowing for selective use of such organic compounds to provide layer clay minerals (C) with swellability to polar solvents and/or non-polar solvents.

Organic compounds intercalated between silicate layers of layer clay minerals may be selected without particular limitations subject to the swellability to a targeted solvent, while preferably primary to quaternary ammonium ions should be used in consideration of the degree of interlayer intercalation by use of ion exchange treatment.

As such primary to quaternary ammonium ions there may be cited tetrabutylammonium ions, tetrahexylammonium ions, dihexyldimethylamminium ions, dioctyldimethylammonium ions, hexatrimethylammonium ions, octatrimethylamminium ions, dodecyltrimethylammonium ions, hexadecyltrimethylammonium ions, stearyltrimethylammonium ions, docosenyltrimethylammonium ions, cetyltrimethylanunonium ions, cetyltriethylamminium ions, hexadecylammonium ions, tetradecyldimethylbenzylamminium ions, stearyldimethylbenzylammonium ions, dioleyldimethylammonium ions, N-methyldiethanollaurylammonium ions, dipropanolmonomethyllaurylammonium ions, dimethylmonoethanollaurylammonium ions, polyoxyethylenedodecylmonomethylammonium ions, dimethylhexadecyloctadecylammonium ions, trioctylmemylammonium ions, tetramethylammonium ions, tetrapropylammonium ions, octadecylammonium ions, dimemyloctadecylammonium ions, dimethyldodecylammonium ions, and the like. Such primary to quaternary ammonium ions may be employed alone or in combination as a mixture of two or more kinds.

Such partial discharge resistant resin composites may have, besides the indispensable ingredients (A) to (C), the above-noted hardening accelerator and/or other additives blended as necessary within the range not to inhibit effects of the invention. For such partial discharge resistant resin composites, as the other additives blended there may be cited anti-dripping agents, anti-settling agents, anti-foaming agents, leveling agents, slip agents, dispersing agents, substrate wetting agents, and the like.

Description is now made of a fabrication method for partial discharge resistant resin composites according to the embodiment described.

First, there is use of an ion exchange treatment for intercalating an organic compound or organic compounds between layers of a layer clay mineral or layer clay minerals of the ingredient (C) described, thereby providing the layer clay mineral or layer clay minerals with swellability to at least one of a polar solvent and a non-polar solvent. As the organic compound or organic compounds to be intercalated between layers of the layer clay mineral or layer clay minerals, preferably, there should be used at least one kind selected from a set of primary to quaternary ammonium ions described. Also, for the reason described, preferably, there should be used any of layer clay minerals having initial particle sizes of 500 nm or less.

This is followed by having the layer clay mineral or layer clay minerals as provided with swellability immersed in a swelling solvent comprising the polar solvent or the non-polar solvent, swelling by a stir, before additionally blending an epoxy resin of the ingredient (A), kneading the mixture. In this mixture, for the reason described, preferably, the layer clay mineral or layer clay minerals should have a blend amount thereof within a range of 1 to 50 parts by weight to 100 parts by weight of the epoxy resin.

After addition of the epoxy resin, the kneading may preferably be performed with high shearing forces acting thereon. This affords in the mixture of epoxy resin to have high shearing forces kneading on the layer clay mineral or layer clay minerals swollen in the solvent with increased interlayer distances between silicate layers thereof, thus allowing for provision of a system of inorganic nanoperticles (of the layer clay mineral or layer clay minerals) the more uniformly dispersed in the epoxy resin.

Such steps provides an amount of mixture including combination of an amount of the epoxy resin and an amount of the swelling solvent with a system of inorganic nanoparticles comprising the layer clay mineral or layer clay minerals. This mixture is let to undergo a process for a removal of the swelling solvent, such as by a vacuum stir drying. This process may include a prewashing employing a low boiling-point solvent incompatible with the epoxy resin but compatible with the swelling solvent used, allowing for a reduced amount of this solvent removed by the vacuum drying.

Next, given a resultant mixture including an amount of the epoxy resin with a system of inorganic nanoparticles comprising the layer clay mineral or layer clay minerals, there comes a step of adding thereto an amount of an epoxy resin addressing hardener of the ingredient (B), for a mixing therewith to obtain a targeted partial discharge resistant resin composite.

The method described includes steps of mixing an epoxy resin of the ingredient (A) with a swelling solvent containing a layer clay mineral or layer clay minerals as swollen, kneading the mixture, obtaining a mixture containing the epoxy resin, the swelling solvent, and the layer clay mineral or layer clay minerals, making a removal of the swelling solvent from this mixture, having a resultant mixture containing the epoxy resin and the layer clay mineral or layer clay minerals, and adding thereto an epoxy resin addressing hardener of the ingredient (B) to mix therewith, while instead there may be steps of mixing an hardener for epoxy resin of the ingredient (B) with a swelling solvent containing a layer clay mineral or layer clay minerals as swollen, kneading the mixture, obtaining a mixture containing the hardener, the swelling solvent, and the layer clay mineral or layer clay minerals, making a removal of the swelling solvent from this mixture, having a resultant mixture containing the epoxy resin addressing hardener and the layer clay mineral or layer clay minerals, and adding thereto an epoxy resin of the ingredient (A) to nix therewith, to obtain a targeted partial discharge resistant resin composite.

Also, there may be a combination of steps of mixing an epoxy resin of the ingredient (A) with a swelling solvent containing a layer clay mineral or layer clay minerals as swollen, and kneading the mixture, producing a first mixture, and steps of mixing hardener of the ingredient (B) with a swelling solvent containing a layer clay mineral or layer clay minerals as swollen, and kneading the mixture, producing a second mixture, followed by steps of making a removal of swelling solvent from the first mixture and the second mixture, and mixing the first mixture and the second mixture after the removal of swelling solvent, to thereby obtain a targeted partial discharge resistant resin composite.

The foregoing partial discharge resistant resin composites undergo a variety of form making or molding processes, such as an impregnation, coating, casting, or sheet formation, to make forms or molds of desirable shapes in accordance with applications of insulation materials. Those forms or molds are cured or hardened through hardening processes corresponding to the kinds of hardeners, to obtain partial discharge resistant insulation materials. It is noted that in the foregoing steps for fabrication of partial discharge resistant resin composites, arbitrary ingredients described are added and mixed as necessary.

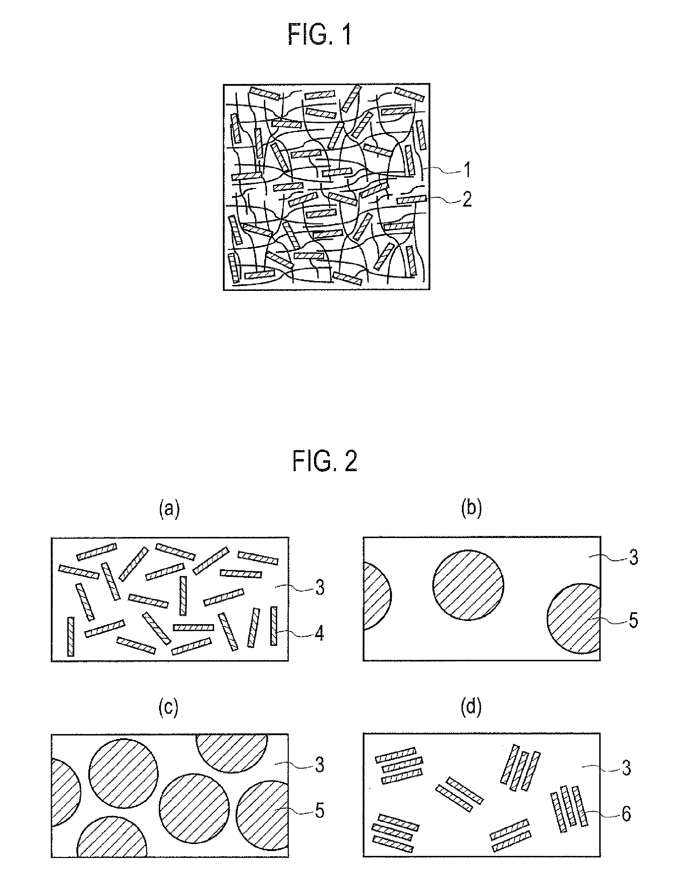

Thus obtained partial discharge resistant insulation materials each have, as illustrated in Fig. 1 for instance, a structure in the form of a cross-linked network of epoxy resin molecular chains (hardened material) 1 constructed by reactions between the ingredient (A) being an epoxy resin and the ingredient (B) being an hardener, including the ingredient (C) as a system of inorganic nanoparticles 2 comprising a layer clay mineral or layer clay minerals evenly and precisely dispersed therein. This allows for provision of a partial discharge resistant insulation material as a hardened epoxy resin with an enhanced partial discharge resistant characteristic due to inclusion of the system of inorganic nanoparticles 2.

Without needing any complicate fabrication process or fabrication method, it affords for good repeatability to provide partial discharge resistant resin composites as well as partial discharge resistant insulation materials with excellent partial discharge resistant characteristics.

Further, according to the present embodiment, there is use of inorganic nanoparticles of nanometer sizes, permitting various amounts of epoxy resin to be filled with smaller amounts of inorganic particles to exhibit excellent partial discharge resistant characteristics, the filled amounts being so small as affording for partial discharge resistant resin composites as well as partial discharge resistant insulation materials to have low-suppressed densities.

The present embodiment affords to provide partial discharge resistant insulation materials well suitable for applications such as those to insulation layers of insulated coils employed in high voltage equipments including electric generators, rotating machines, and the like, insulation coatings of enamel wires employed in industrial motors or the like, and insulating support members for high voltage conductors employed in equipments for electric transmission and transformation (as high voltage equipments) including gas-insulated switchgears, gas-insulated transmission lines, and the like. Insulated coils employed in electric generators, rotating machines, or the like are configured with a coil conductor for conducting a high-voltage current, and an insulation layer for isolation between coil conductors and that of coil conductors to the ground. Insulation layers of insulated coils fabricated may have, for instance, mica papers impregnated and coated with insulating resin composites to be hardened. Insulating support members for high voltage conductors employed in high voltage equipments such as electric transmission and transformation equipments are configured for high voltage conductors to be insulated and supported in metal casings, in the form of an amount of insulating resin composite casted and hardened as a cast insulator, for instance. Enamel wires employed in industrial motors or the like are configured with an element wire for conducting a high-voltage current, and an insulation coating for isolation between element wires and that of element wires to the ground. Insulation coatings of enamel wires fabricated may comprise a hardened coat of partial discharge resistant resin composite.

Such the partial discharge resistant insulation materials can be used for various applications including not simply those described such as insulation layers of insulated coils, insulation coatings of enamel wires, and insulating support members for high voltage conductors (cast insulators), but also as turbine end finish varnishes for generators, insulation rods for breakers, insulation paints, formed insulation components, impregnation resins for FRP, cable sheath materials, and the like. Further, in some cases, they may be applied as or to highly heat conductive insulation sheets for power unit insulating sealants, IC substrates, LSI device addressing interlayer insulation films, stacking substrates, semiconductor addressing sealants, and the like.

Such being the case, the present invention provides partial discharge resistant insulation materials adapted for use in various applications. In this regard, industrial and heavy electrical machinery as well as electric or electronic equipment has been exposed to recent trends such as those to implement smaller sizes, larger capacities, higher frequency bands, or higher voltages, under usage environments with augmented severities or such, and accompanied by desiderata such as those to implement higher performances, higher integrities, higher qualities, or higher stabilities, for instance such as those to improve partial discharge resistant characteristics in cast insulators, impregnated insulation materials, or the like. The present invention provides partial discharge resistant insulation materials meeting such demands, affording for selective use of those constituent materials described to apply as epoxy cast insulators, epoxy impregnated insulation materials, epoxy resin insulation covers, or the like, to various industrial and heavy electrical machinery and electric or electronic equipment.

### Examples

Description is now made of specific embodiment examples of the present invention and their evaluation results.

### (Embodiment example 1)

There was a layer clay mineral (Kunimine Kogyo Co. Ltd. make, article name: Kunipia® F) prepared with an octadecylamine (Lion Akzo Co. Ltd. make, article name: Amine® 18D) intercalated between layers thereof by an intercalation treatment in an acidic solution, which was added by 10 parts by weight to 50 parts by weight of dimethylacetamide, and stirred to swell, before adding thereto 100 parts by weight of a bisphenol A type epoxy resin (Japan Epoxy Resin Co. make, article name: Epikote® 828), making a preliminary stir followed by kneading with high shearing forces using a three-roll mill. This mixture was washed by a plenty of distilled water for removing dimethylacetamide, before a pressure-reduced drying made to remove residual distilled water, obtaining a mixture of epoxy resin with a system of inorganic nanoparticles evenly dispersed therein. To this mixture there was made an addition of 86 parts by weight of an acid anhydride series hardener (New Japan Chemical Co. make, article name: Rikacid® MH-700) and 1 part by weight of a curing accelerator (Nihon Yushi Co. make, article name: M2-100), followed by a mixing made at 80°C for 10 minutes, preparing a partial discharge resistant resin composite. This insulating resin composite was poured into a mold preheated to 100°C, and vacuum-degassing, before a hardening process implemented under conditions of 100°C x 3 hours (primary hardening) + 150°C x 15 hours (secondary hardening), making a targeted partial discharge resistant insulation material. This partial discharge resistant insulation material was used in later-described characteristic evaluations.

### (Comparative example 1)

To 100 parts by weight of a bisphenol A type epoxy resin (Japan Epoxy Resin Co. make, article name: Epikote® 828), there was made an addition of 10 parts by weight of silica particles (Tatsumori Co. make, article name: Crystalight® A1) having an initial particle size of 12µm, followed by kneading. To this knead mixture there was made an addition of 86 parts by weight of an epoxy resin addressing acid anhydride series hardener (New Japan Chemical Co. make, article name: Rikacid® MH-700) and 1 part by weight of a curing accelerator (Nihon Yushi Co. make, article name: M2-100), followed by a mixing made at 80°C for 10 minutes, preparing a partial discharge resistant resin composite. This insulating resin composite was poured into a mold preheated to 100°C, and vacuum-degassing, before a hardening process implemented under conditions of 100°C x 3 hours (primary hardening) + 150°C x 15 hours (secondary hardening), making an insulation material. This insulation material was used in later-described characteristic evaluations.

### (Comparative example 2)

To 100 parts by weight of a bisphenol A type epoxy resin (Japan Epoxy Resin Co. make, article name: Epikote® 828), there was made an addition of 200 parts by weight of silica particles (Tatsumori Co. make, article name: Crystalight® A1) having an initial particle size of 12µm, followed by kneading. To this knead mixture there was made an addition of 86 parts by weight of an epoxy resin addressing acid anhydride series hardener (New Japan Chemical Co. make, article name: Rikacid® MH-700) and 1 part by weight of a curing accelerator (Nihon Yushi Co. make, article name: M2-100), followed by a mixing made at 80°C for 10 minutes, preparing a partial discharge resistant resin composite. This partial discharge resistant resin composite was poured into a mold preheated to 100°C, and vacuum-degassing, before a hardening process implemented under conditions of 100°C x 3 hours (primary hardening) + 150°C x 15 hours (secondary hardening), making an insulation material. This insulation material was used in later-described characteristic evaluations.

### (Comparative example 3)

To 100 parts by weight of a bisphenol A type epoxy resin (Japan Epoxy Resin Co. make, article name: Epikote® 828), there was made an addition of 10 parts by weight of a layer clay mineral (Kunimine Kogyo Co. Ltd. make, article name: Kunipia® F) having sodium ions held between layers thereof, followed by kneading. To this knead mixture there was made an addition of 86 parts by weight of an epoxy resin addressing acid anhydride series hardener (New Japan Chemical Co. make, article name: Rikacid® MH-700) and 1 part by weight of a curing accelerator (Nihon Yushi Co. make, article name: M2-100), followed by a mixing made at 80°C for 10 minutes, preparing a partial discharge resistant resin composite. This partial discharge resistant resin composite was poured into a mold preheated to 100°C, and vacuum-defoamed, before a hardening process implemented under conditions of 100°C x 3 hours (primary hardening) + 150°C x 15 hours (secondary hardening), making an insulation material. This insulation material was used in later-described characteristic evaluations.

Those inorganic nanoparticles used in the above-noted embodiment example 1 and comparative examples 1 to 3 had differences in between, which are listed together in Table 1. For the partial discharge resistant insulation material according to the embodiment example 1 and the insulation materials according to the comparative examples 1 to 3, respectively, dispersed states of their inorganic nanoparticles were observed and investigated by a TEM (transmission electron microscope) or XRD (X-ray diffraction measurement), with resultant dispersion states schematically illustrated in Figs. 2(a) to 2(d).

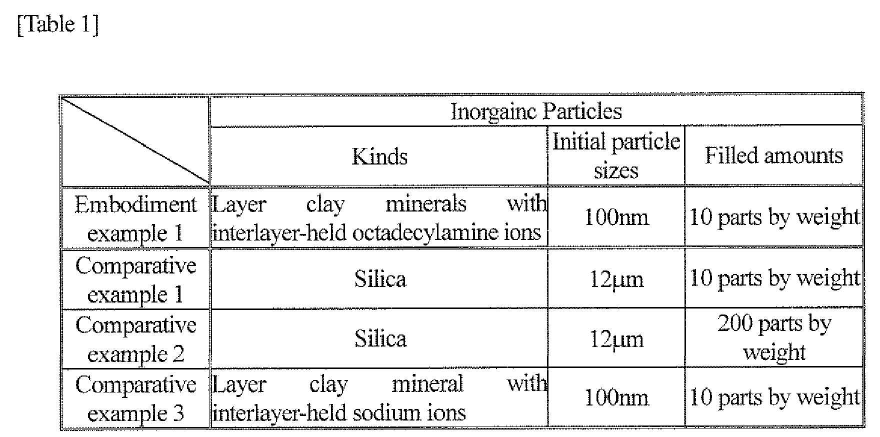

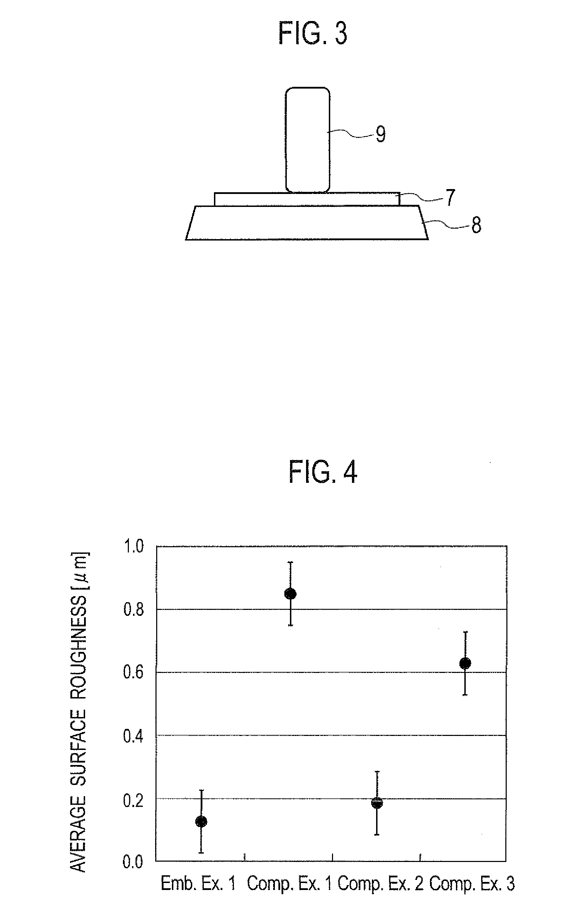

Next, there were evaluations made of partial discharge resistant characteristics of the partial discharge resistant insulation material according to the embodiment example 1 and the insulation materials according to the comparative examples 1 to 3, respectively. There were 30 mm x 30 mm x 1 mm test specimens 7, which were each surface-polished and, as illustrated in Fig. 3, placed on a planar electrode 8. Then, using a bar electrode (IEC(b)) 9, a 6 kV voltage was applied to the test specimen 7, causing partial discharges on the surface. After 48-hour continuation of the voltage application, about a location off at a 1 mm outside of the bar electrode 9, there was measured an average surface roughness within a region of 1 mm x 1 mm, using a laser microscope (Keyence Co. make, article name VK-8550). For the embodiment example 1 and the comparative examples 1 to 3, results of their measurements of average surface roughness are plotted in Fig. 4.

As will be apparent from measurement results of surface roughness in Fig. 4, it is found that the partial discharge resistant insulation material according to the embodiment example 1 was less roughed by discharges on the surface, and excellent in partial discharge resistant characteristic, relative to the insulation materials according to the comparative examples 1 to 3. There will be described specific behaviors and effects of the present invention, with reference to comparison between the embodiment example 1 and the comparative examples.

First, comparison is made between the embodiment example 1 and the comparative example 1. For the partial discharge resistant insulation material according to the embodiment example 1, there was an amount of layer clay mineral prepared with an initial particle size of 100 nm, having octadecylamine ions as inorganic nanoparticles held in interlayer spaces by an intercalation treatment, which was subjected to a swelling in an organic solvent (dimethylacetamide) and filled by 10 parts by weight in an epoxy resin, kneading the mixture with high shearing forces before making a removal of the organic solvent. On the other hand, for the comparative example 1, there was an amount of silica particles prepared with an initial particle size of 12µm, which was filled by 10 parts by weight in an epoxy resin.

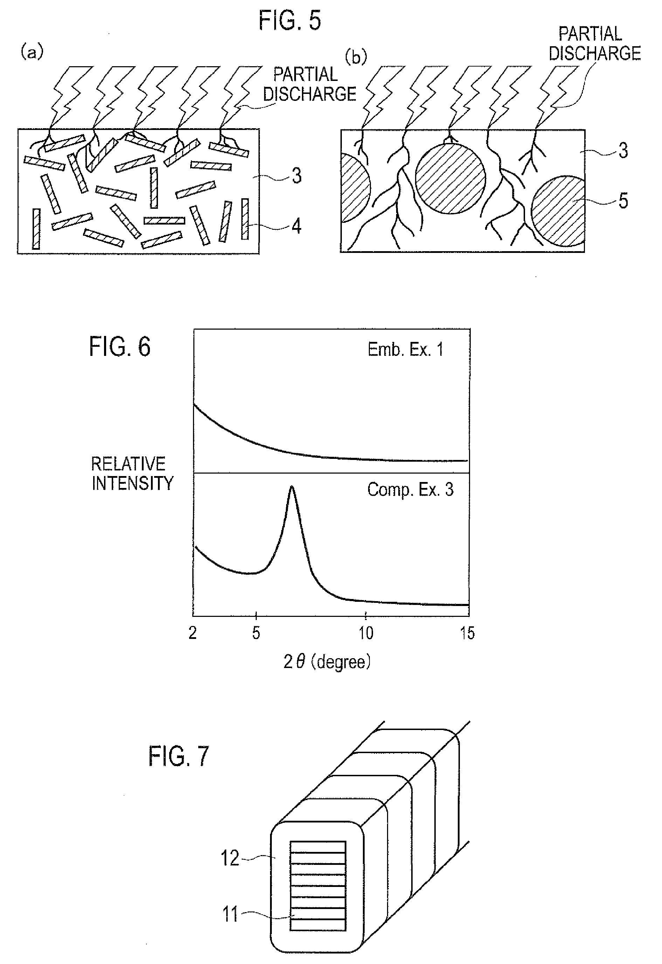

It is seen from measurement results of surface roughness in Fig. 4 that, providing an equivalent amount of filled inorganic particles, the difference of initial particle size largely affects partial discharge resistant characteristics. According to the embodiment example 1, as illustrated in Fig. 2(a), the partial discharge resistant insulation material was fabricated with nanometer-sized particles of layer clay mineral 4 densely dispersed in an epoxy resin 3, so as illustrated in Fig. 5(a), its erosion by partial discharges could be blocked to suppress. To the contrary, according to the comparative example 1, as illustrated in Fig. 2(b), the insulation material was fabricated with micrometer-sized silica particles 5 dispersed in an epoxy resin 3, so as illustrated in Fig. 5(b), the epoxy resin 3 was eroded by partial discharges between silica particles 5.

Such being the case, the partial discharge resistant insulation material according to the embodiment example 1, using nanometer-sized inorganic particles, was provided with an excellent resistant property to partial discharges.

Next, comparison is made between the embodiment example 1 and the comparative example 2. For the embodiment example 1, there was an amount of layer clay mineral prepared with an initial particle size of 100 nm, having octadecylamine ions held in interlayer spaces, which was filled by 10 parts by weight in an epoxy resin. On the other hand, for the comparative example 2, there was an amount of silica particles prepared with an initial particle size of 12µm, which was filled by 200 parts by weight in an epoxy resin, having as illustrated in Fig. 2(c) micrometer-sized silica particles 5 densely dispersed in the epoxy resin 3.

It is ensured in Fig. 4 that the degree of surface roughness after deterioration by partial discharges was not so large between the partial discharge resistant insulation material according to the embodiment example 1 and the insulation material according to the comparative example 2. In this respect, there was made a comparison between a density of the partial discharge resistant insulation material according to the embodiment example 1 being 1.12 (g/cm³) and a density of the insulation material according to the comparative example 2 being 1.68 (g/cm³), to know that the density of insulation material of the comparative example 2 was 1.5 folds of, and greater than, that of partial discharge resistant insulation material of the embodiment example 1.

According to the embodiment example 1, such the partial discharge resistant insulation material, using nanometer-sized inorganic particles, was enabled by filing mere 10 parts by weight of inorganic particles to exhibit a partial discharge resistant characteristic similar to what was given by filling 200 parts by weight of micrometer-sized inorganic particles, and could do with a reduced fill amount, having a material density successfully suppressed small, finally affording to have light-weighted insulated coils, enameled wires, and cast insulation materials.

Next, comparison is made between the embodiment example 1 and the comparative example 3. For the embodiment example 1, there was an amount of layer clay mineral prepared with octadecylamine ions held in interlayer spaces, which was subjected to a swelling in an organic solvent (dimethylacetamide) and mixed by 10 parts by weight in an epoxy resin, kneading the mixture with high shearing forces before making a removal of the organic solvent to complete a filling, while for the comparative example 3, there was an amount of layer clay mineral having sodium ions in interlayer spaces, which was mixed by 10 parts by weight in an epoxy resin, kneading the mixture with high shearing forces to complete a filling. This difference affected a dispersion state of particles of layer clay mineral in epoxy resin. To grasp the states of particles of layer clay mineral dispersed in the epoxy resins, the partial discharge resistant insulation material according to the embodiment example 1 and the insulation material according to the comparative example 3 were each abrasion-processed by sandpaper (# 240), and fixed to a measurement folder of an X-ray diffraction meter (Rigaku Co. make, model: XRD-B, CuKα beam), making measurements within a range of 2θ= 0 to 10 degrees, getting results shown in Fig. 6.

Layer clay minerals are fine particles having a structure of laminated sheets (silicate layers) each comprised of a two-dimensional array of SiO₄ tetrahedrons or octahedrons. X-ray diffraction measurements provide a reflection peak within a range of 2 θ = 2 to 20 degrees. That is a peak derived from interlayer diffractions in layer clay mineral particles, meaning presence of particles of layer clay mineral that have lamination structures left as they are in a resin. And, absent any defined reflection peak within the range of 2 θ = 0 to 10 degrees, there should be particles of layer clay mineral having their layers delaminated, constituting a uniform dispersion system of delaminated layers. For the embodiment example 1, the XRD measurement had a result free of reflection peak within the range of 2 θ = 0 to 10 degrees.

That is, as illustrated in Fig. 2(a), in the partial discharge resistant insulation material according to the embodiment example 1 there should have been particles of layer clay mineral 4 having their layers delaminated, constituting a uniform dispersion system. On the other hand, for the comparative example 3, there was a strong reflection peak observed at a 2 θ = 7 degrees. This indicates presence of particles of layer clay mineral 6 mixed in an epoxy resin 3 that had, as illustrated in Fig. 2(d), lamination structures left as they were in the epoxy resin 3.

In particles of layer clay mineral prepared with octadecylamine ions in interlayer spaces, their silicate layers have surface energies reduced by octadecylamine ions, and interlayer spaces have lipophilic atmospheres, so those particles tend to exhibit enhanced behaviors such as those in swellability to organic solvents or affinity for epoxy resins. Such effects of octadecylammonium ion derived from octadecylamine help them swell in a solvent, increasing interlayer distances, before kneading a mixture with an epoxy resin, giving high shearing stresses, causing layers of layer clay mineral to delaminate, so that peeled layers are uniformly dispersed in an insulation material. To the contrary, in the comparative example 3, particles of layer clay mineral prepared with sodium ions in interlayer spaces had a low affinity for the epoxy resin. As a result, even in a mixture knead with high shearing stresses, these particles of layer clay mineral were unable to be uniformly dispersed in the insulation material.

Pieces or particles of layer clay mineral uniformly dispersed in an epoxy resin like the embodiment example 1 work to suppress deteriorations due to partial discharges, affording to provide the epoxy resin with an excellent partial discharge resistant property. This is why in Fig. 4 the surface roughness after partial discharge deterioration is reduced.

There will be described partial discharge resistant insulation structures using partial discharge resistant insulation materials according to aspects of the present invention with reference to Fig. 7 to Fig. 9, respectively.

Fig. 7 is an illustration of an insulated coil applicable to high voltage equipment such as electric generators or rotating machines. In Fig. 7, about a set of high voltage current conducting coil conductors 11, there is provided an insulation layer 12 configured for isolation between the set of coil conductors 11 and the ground as well as between sets of coil conductors 11. The insulation layer 12 may be composed of e.g. mica paper impregnated and coated with a partial discharge resistant resin composite according to an aspect of the present invention, and hardened.

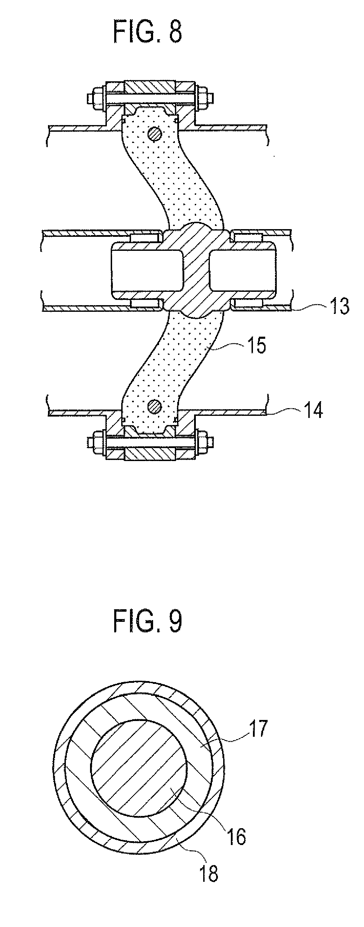

Fig. 8 is an illustration of an insulation member applicable to gas-insulated switchgears. In Fig. 8, there is a high voltage conductor 13 insulated and supported by the insulation member 15 in an insulating gas (sulfur hexafluoride gas) sealing metallic container 14. The insulation member 15 is comprised of a cast insulator made of a partial discharge resistant resin composite according to an aspect of the present invention as casted and hardened.

Fig. 9 illustrates a section of an enameled wire applicable to industrial motors and the like. About a set of high voltage current conducting element-wire conductors 16, it has an insulation clad 17 configured for isolation between the set of element-wire conductors 16 and the ground as well as between sets of element-wire conductors 16, and an insulating protection sheath 18 surrounding the insulation clad 17. The insulation clad 17 may be made up as a hardened coat of a partial discharge resistant resin composite according to an aspect of the present invention.

Like examples in Fig. 7 to Fig. 9, partial discharge resistant insulation structures using partial discharge resistant insulation materials according to aspects of the present invention allow for enhanced characteristics or integrity of high voltage equipment.

It is noted that the present invention is not limited to implementing the foregoing embodiments as they are, and may be specifically implemented with modified components without departing from the scope in the stage of practice. Further, constituent components disclosed in any embodiment described may be combined as necessary to implement a certain aspect of the present invention. For instance, the embodiment may have a certain component or components omitted out of the whole components described. In addition, constituent components of different embodiments may be combined as necessary.

### Industrial Applicability

According to the present invention, there are partial discharge resistant resin composites and partial discharge resistant insulation materials obtainable with excellent partial discharge resistant properties and small densities, and partial discharge resistant insulation materials according to the present invention are applicable as epoxy-casted insulators, epoxy-impregnated insulators, epoxy resin insulating coatings, or the like to various industrial or heavy electric machinery, and electric or electronic equipment.

## Claims

1. A fabrication method for partial discharge resistant resin composites containing (A) an epoxy resin having two or more epoxy groups per one molecule, (B)a hardener for an epoxy resin, and (C) a layer clay mineral as indispensable ingredients, the fabrication method for partial discharge resistant resin composites comprising steps of:
using an ion exchange treatment for intercalating an organic compound between layers of a layer clay mineral thereby providing the layer clay mineral with a swellability to at least one of a polar solvent and a non-polar solvent;
having the layer clay mineral as provided with a swellability swollen in a swelling solvent comprising the polar solvent or the non-polar solvent;
kneading a mixture of an epoxy resin and the swelling solvent including the layer clay mineral as swollen;
making a removal of the swelling solvent from the mixture including the swelling solvent, the layer clay mineral, and the epoxy resin after the kneading; and
mixing a hardener with the mixture after the removal of the swelling solvent.

2. The fabrication method for partial discharge resistant resin composites according to claim 1, wherein the layer clay mineral belongs to at least one kind selected from a set of mineral groups comprised of a smectite group, a mica group, a vermiculite group, and a mica family group.

3. The fabrication method for partial discharge resistant resin composites according to claim 1, wherein the organic compound to be intercalated between layers of the layer clay mineral in the providing the swellability comprises at least one kind selected from primary to quaternary ammonium ions.

4. The fabrication method for partial discharge resistant resin composites according to claim 2, wherein the organic compound to be intercalated between layers of the layer clay mineral in the providing the swellability comprises at least one kind selected from primary to quaternary ammonium ions.

5. A partial discharge resistant resin composite fabricated by a fabrication method for partial discharge resistant resin composites according to claim 1 or claim 4.

6. A partial discharge resistant insulation material comprising a hardened material of a partial discharge resistant resin composite according to claim 5.
